# EUROPEAN PATENT APPLICATION

(11) **EP 3 786 672 A1**
(43) Date of publication of application: **03.03.2021**
(21) Application number: 19793556.2
(22) Date of filing: 26.04.2019
(51) Int. Cl.: G02B 1/04

(54) **OPTICAL COMPONENT FORMING COMPOSITION, AND CURED ARTICLE THEREOF**

(30) Priority: 27.04.2018 JP 2018086027
(71) Applicant: MITSUBISHI GAS CHEMICAL COMPANY, INC., Chiyoda-ku Tokyo 100-8324 (JP)
(72) Inventor: SATO, Takashi, Hiratsuka-shi, Kanagawa 254-0016 (JP); ECHIGO, Masatoshi, Tokyo 100-8324 (JP)
(74) Representative: Müller-Boré & Partner Patentanwälte PartG mbB
(86) International application number: PCT/JP2019/017906
(87) International publication number: WO 2019/208763

(57) **Abstract**

An optical component forming composition containing a compound represented by the following formula (1).

[LₓTe(OR¹)_{y}] (1)

wherein:
L is a ligand other than OR¹;
R¹ is any of: a hydrogen atom; a substituted or unsubstituted, linear alkyl group having 1 to 20 carbon atoms, or branched or cyclic alkyl group having 3 to 20 carbon atoms; a substituted or unsubstituted aryl group having 6 to 20 carbon atoms; a substituted or unsubstituted alkenyl group having 2 to 20 carbon atoms; and a substituted or unsubstituted alkynyl group having 2 to 20 carbon atoms;
x is an integer of 0 to 6;
y is an integer of 0 to 6;
a sum of x and y is 1 to 6;
when x is 2 or more, a plurality of L may be the same or different; and
when y is 2 or more, a plurality of R¹ may be the same or different.

## Description

### Technical Field

The present invention relates to an optical component forming composition and a cured product thereof.

### Background Art

In recent years, various compositions have been proposed as optical component forming compositions. Examples of such optical component forming compositions include, for example, a composition comprising an acrylic resin, an epoxy-based resin or an anthracene derivative (see, for example, Patent Literatures 1 to 4 below). On the other hand, Non Patent Literatures 1 to 3 disclose polymers containing tellurium.

### Citation List

### Patent Literature

Patent Literature 1: Japanese Patent Laid-Open No. 2016-12061
Patent Literature 2: Japanese Patent Laid-Open No. 2015-174877
Patent Literature 3: Japanese Patent Laid-Open No. 2014-73986
Patent Literature 4: Japanese Patent Laid-Open No. 2010-138393

### Non Patent Literature

Non Patent Literature 1: Chem. Lett., 40,762-764 (2011)
Non Patent Literature 2: Angew. Chem. Int. Ed. 49, 10140-10144 (2010).
Non Patent Literature 3: Org. Lett., 11, 1487-1490 (2009).

### Summary of Invention

### Technical Problem

However, although a large number of compositions for optical members have heretofore been suggested, none of these compositions achieve all of storage stability, structure forming ability (film forming ability), heat resistance, transparency and refractive index at high levels. Thus, the development of novel materials is required. Furthermore, although Non Patent Literatures 1 to 3 disclose polymers containing tellurium, application of the polymers containing tellurium as optical component forming compositions is not disclosed.

Therefore, an object of the present invention is to provide an optical component forming composition that is excellent in optical characteristics, and a cured product thereof.

### Solution to Problem

More specifically, the present invention is as follows.
[1] An optical component forming composition comprising a compound represented by the following formula (1):

   [LₓTe(OR¹)_{y}] (1)

   wherein:
   L is a ligand other than OR¹;
   R¹ is any of: a hydrogen atom; a substituted or unsubstituted, linear alkyl group having 1 to 20 carbon atoms, or branched or cyclic alkyl group having 3 to 20 carbon atoms; a substituted or unsubstituted aryl group having 6 to 20 carbon atoms; a substituted or unsubstituted alkenyl group having 2 to 20 carbon atoms; and a substituted or unsubstituted alkynyl group having 2 to 20 carbon atoms;
   x is an integer of 0 to 6;
   y is an integer of 0 to 6;
   a sum of x and y is 1 to 6;
   when x is 2 or more, a plurality of L may be the same or different; and
   when y is 2 or more, a plurality of R¹ may be the same or different.
[2] The optical component forming composition according to [1], wherein, in the compound represented by the above formula (1), x is an integer of 1 to 6.
[3] The optical component forming composition according to [1] or [2], wherein, in the compound represented by the above formula (1), y is an integer of 1 to 6.
[4] The optical component forming composition according to any of [1] to [3], wherein, in the compound represented by the above formula (1), R¹ is, a substituted or unsubstituted, linear alkyl group having 1 to 6 carbon atoms, or branched or cyclic alkyl group having 3 to 6 carbon atoms.
[5] The optical component forming composition according to any of [1] to [4], wherein, in the compound represented by the above formula (1), L is a bi- or higher- dentate ligand.
[6] The optical component forming composition according to any of [1] to [5], wherein, in the compound represented by the above formula (1), L is any of acetylacetonato, 2,2-dimethyl-3,5-hexanedione, ethylenediamine, diethylenetriamine and methacrylic acid.
[7] The optical component forming composition according to any of [1] to [6], further comprising a solvent.
[8] The optical component forming composition according to any of [1] to [7], further comprising an acid generating agent.
[9] The optical component forming composition according to any of [1] to [8], further comprising an acid crosslinking agent.
[10] The optical component forming composition according to any of [1] to [9], further comprising an acid diffusion controlling agent.
[11] The optical component forming composition according to any of [1] to [10], further comprising a polymerization initiator.
[12] A cured product obtained by using the optical component forming composition according to any of [1] to [11].

### Advantageous Effects of Invention

According to the present invention, an optical component forming composition that is excellent in optical characteristics, and a cured product thereof can be provided.

### Description of Embodiments

Hereinafter, an embodiment of the present invention will be described (hereinafter, referred to as the "present embodiment"). Note that the present embodiment is given in order to illustrate the present invention. The present invention is not limited to only the present embodiment.

### [Optical component forming composition]

An optical component forming composition of the present embodiment is an optical component forming composition containing a compound represented by the following formula (1) (also referred to as the "tellurium-containing compound"). Since the optical component forming composition of the present embodiment contains tellurium, it has high refractive index and high transparency, and further has excellent storage stability and structure forming ability (film forming ability). In addition, a cured product obtained by curing the optical component forming composition of the present embodiment has high refractive index and high transparency while being prevented from being stained by a heat treatment in a wide range from a low temperature to a high temperature. The optical component forming composition of the present embodiment has high heat resistance.

### <Tellurium containing compound>

The tellurium-containing compound in the present embodiment is a compound represented by the following formula (1).

[LₓTe(OR¹)_{y}] (1)

In the formula (1):
L is a ligand other than OR¹;
R¹ is any of: a hydrogen atom; a substituted or unsubstituted, linear alkyl group having 1 to 20 carbon atoms, or branched or cyclic alkyl group having 3 to 20 carbon atoms; a substituted or unsubstituted aryl group having 6 to 20 carbon atoms; a substituted or unsubstituted alkenyl group having 2 to 20 carbon atoms; and a substituted or unsubstituted alkynyl group having 2 to 20 carbon atoms;
x is an integer of 0 to 6;
y is an integer of 0 to 6;
a sum of x and y is 1 to 6;
when x is 2 or more, a plurality of L may be the same or different; and
when y is 2 or more, a plurality of R¹ may be the same or different.

Examples of R¹ include any of:
a hydrogen atom;
a substituted or unsubstituted, linear alkyl group having 1 to 20 carbon atoms, or branched or cyclic alkyl group having 3 to 20 carbon atoms;
a substituted or unsubstituted aryl group having 6 to 20 carbon atoms;
a substituted or unsubstituted alkenyl group having 2 to 20 carbon atoms; and
a substituted or unsubstituted alkynyl group having 2 to 20 carbon atoms.

When there are a plurality of R¹, R¹ may be the same as or different from each other.

Specific examples of R¹ include, for example, a methyl group, an ethyl group, a propyl group, a butyl group, a pentyl group, a hexyl group, a heptyl group, an octyl group, a nonyl group, a decyl group, an undecyl group, a dodecyl group, an icosyl group, a cyclopropyl group, a cyclobutyl group, a cyclopentyl group, a cyclohexyl group, a cycloheptyl group, a cyclooctyl group, a cyclononyl group, a cyclodecyl group, a cycloundecyl group, a cyclododecyl group, a cycloicosyl group, a norbornyl group, an adamantyl group, a phenyl group, a naphthyl group, an anthracene group, a pyrenyl group, a biphenyl group, a heptacene group, a vinyl group, a propenyl group, a butenyl group, a pentenyl group, a hexenyl group, an ethynyl group, a propynyl group, an icosynyl group and a propargyl group. These groups follow a concept of encompassing isomers, and for example, a butyl group is not limited to a n-butyl group, and may be an isobutyl group, a sec-butyl group or a tert-butyl group. In addition, these groups may have a substituent as long as the number of carbon atoms does not exceed 20, and examples of the substituent include one functional group selected from the group consisting of a carboxyl group, an acryl group and a methacryl group, as well as groups containing these groups.

Among the above, from the viewpoint of curability and solubility, R¹ is preferably a linear alkyl group having 1 to 6 carbon atoms or branched or cyclic alkyl group having 3 to 6 carbon atoms, and is more preferably a linear alkyl group having 1 to 4 carbon atoms or branched or cyclic alkyl group having 3 to 4 carbon atoms. When it has a substituent, that substituent is preferably one or more selected from the group consisting of a carboxyl group, a group containing a carboxyl group, an acrylate group and a methacrylate group, and is more preferably one or more selected from the group consisting of an acrylate group and a methacrylate group.

L is a ligand other than OR¹, and may be a monodentate ligand or a multidentate ligand of a bi- or higher- dentate ligand. When there are a plurality of L, L may be the same as or different from each other.

Specific examples of the monodentate ligand include acrylate, methacrylate, amine, chloro, cyano, thiocyano, isothiocyano, nitro, nitrito, triphenylphosphine, pyridine and cyclopentene. Specific examples of the multidentate ligand include, for example, ethylenediamine, acetylacetonato, 2,2-dimethyl-3,5-hexanedione, diethylenetriamine, acrylic acid, methacrylic acid and ethylenediaminetetraacetic acid.

From the viewpoint of flattening properties, L is preferably a multidentate ligand of a bi- or higher-dentate ligand, is more preferably any of acetylacetonato, 2,2-dimethyl-3,5-hexanedione, ethylenediamine, diethylenetriamine and methacrylic acid, and is still more preferably any of acetylacetonato, 2,2-dimethyl-3,5-hexanedione and methacrylic acid.

x is an integer of 0 to 6, y is an integer of 0 to 6, and x + y is 1 to 6. From the viewpoint of solubility in a safe solvent, x is preferably an integer of 1 to 6, is more preferably an integer of 1 to 4, and is still more preferably 1 or 2. From the viewpoint of curability and heat resistance, y is preferably an integer of 1 to 6, is more preferably an integer of 1 to 4, and is still more preferably an integer of 2 to 4.

The tellurium-containing compound is preferably a compound represented by the following formula (1-1), the following formula (1-2) or the following formula (1-3).

[Te(OR¹)₄] (1-1)

(In the formula (1-1), R¹ is as defined in the formula (1).) 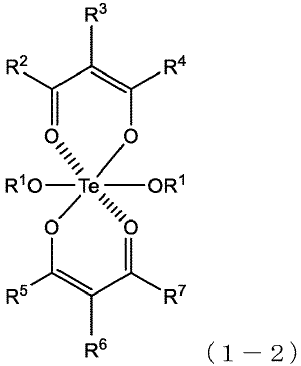 In the formula (1-2), R¹ is as defined in the formula (1) ; and R², R³, R⁴, R⁵, R⁶ and R⁷ may be the same or different, and are each independently:
a hydrogen atom;
a substituted or unsubstituted, linear alkyl group having 1 to 20 carbon atoms, or branched or cyclic alkyl group having 3 to 20 carbon atoms;
a substituted or unsubstituted aryl group having 6 to 20 carbon atoms;
a substituted or unsubstituted alkenyl group having 2 to 20 carbon atoms; or
a substituted or unsubstituted alkynyl group having 2 to 20 carbon atoms. 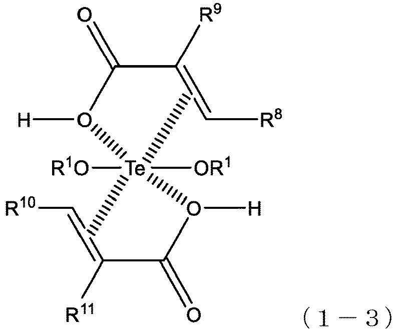
In the formula (1-3), R¹ is as defined in the formula (1); R⁹ and R¹¹ may be the same or different, and are each independently a hydrogen atom or a methyl group; and R⁸ and R¹⁰ may be the same or different, and are each independently:
a hydrogen atom;
a substituted or unsubstituted, linear alkyl group having 1 to 20 carbon atoms, or branched or cyclic alkyl group having 3 to 20 carbon atoms;
a substituted or unsubstituted aryl group having 6 to 20 carbon atoms;
a substituted or unsubstituted alkenyl group having 2 to 20 carbon atoms; or
a substituted or unsubstituted alkynyl group having 2 to 20 carbon atoms.

Although the tellurium-containing compound in the present embodiment is not particularly limited, examples thereof include the following compounds. Among them, a compound represented by the formula (TOX-1), the formula (TOX-2), the formula (TOX-3) or the formula (TOX-4) is preferable.

Te(OEt)₄ (TOX-1)

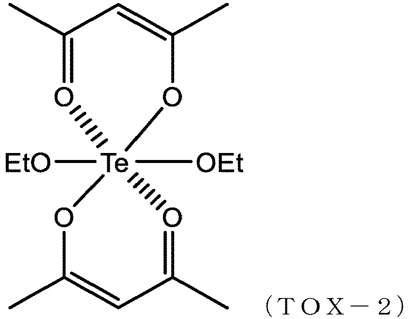

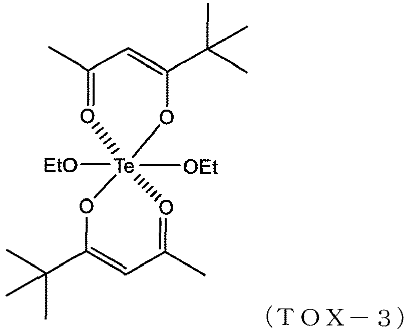

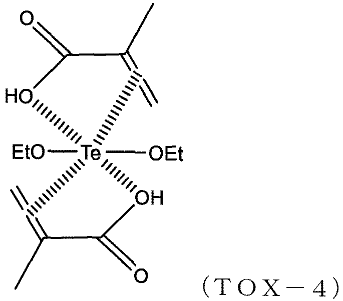

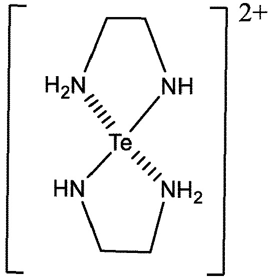

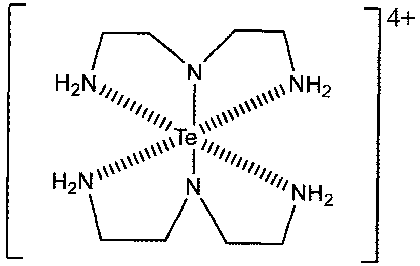

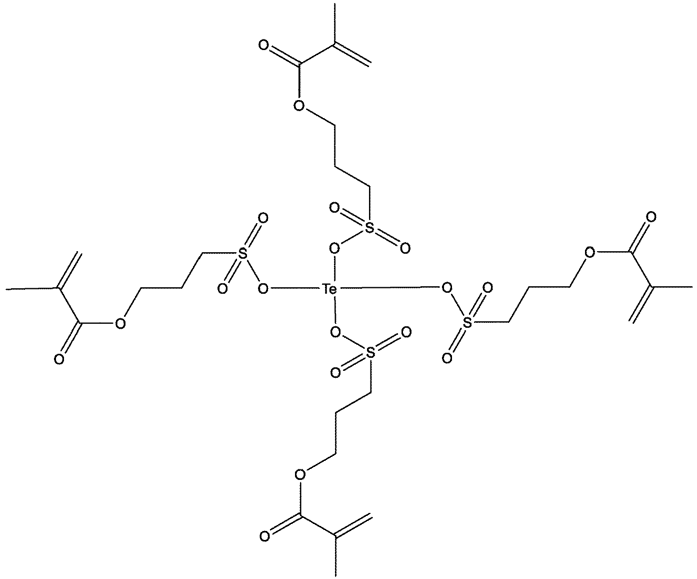

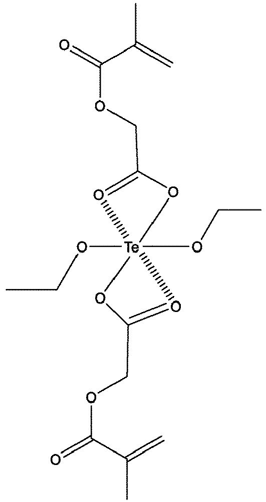

### (Method for producing tellurium-containing compound)

The tellurium-containing compound according to the present embodiment is obtained by, for example, the following method. That is, by heating metal tellurium or tellurium dioxide in a chlorine gas stream to about 500°C, tellurium tetrachloride is obtained. Next, by allowing the obtained tellurium tetrachloride to react with sodium alkoxide under ice cooling with no catalyst, an alkoxy tellurium compound, wherein x is 0 and y is 1 or more in the formula (1), can be obtained. For example, a compound represented by the formula (TOX-1) mentioned above (tetraethoxytellurium(IV)) can be obtained by allowing tellurium tetrachloride to react with ethanol. Alternatively, the tellurium-containing compound can be obtained through electrolysis using metal tellurium as the positive electrode.

In the present embodiment, L, which is a ligand other than OR¹, can be obtained by a variety of methods. For example, a tellurium-containing compound to which L is coordinated can be obtained by mixing and stirring an alkoxy tellurium compound or metal tellurium dissolved in an organic solvent such as tetrahydrofuran and a ligand L dissolved in an organic solvent such as tetrahydrofuran, and removing the organic solvent. A specific example is shown below. That is, when tetraethoxytellurium(IV) (a compound represented by the formula (TOX-1) mentioned above) is used as an alkoxy tellurium compound, by placing 1.0 g of tetraethoxytellurium(IV) represented by the formula (TOX-1) dissolved in 20 mL of tetrahydrofuran in a container with an inner volume of 100 mL equipped with a stirrer, a condenser tube and a burette, further adding 0.6 g of acetylacetone dissolved in 5 mL of tetrahydrofuran, allowing the resultant mixture to reflux for 1 hour, and removing the solvent under reduced pressure, a compound represented by the formula (TOX-2) mentioned above can be obtained.

Besides, for example, by stirring an aqueous solution of sodium tellurite and a carboxylic acid, a tellurium-containing compound to which carboxylate is coordinated is readily produced.

### (Method for purifying tellurium-containing compound)

The tellurium-containing compound of the present embodiment can be purified by a purification method including the following steps. The purification method includes a step of dissolving the tellurium-containing compound in a solvent containing an organic solvent that does not inadvertently mix with water to obtain a solution (A), and a step of bringing the obtained solution (A) into contact with an acidic aqueous solution, thereby extracting impurities in the tellurium-containing compound (a first extraction step). According to the purification method of the present embodiment, the contents of various metals that may be contained as impurities in the compound having a specific structure mentioned above can be reduced effectively.

Metals contained in the solution (A) containing the tellurium-containing compound are transferred to the aqueous phase, then the organic phase and the aqueous phase are separated, and thus the tellurium-containing compound having a reduced metal content can be obtained.

The tellurium-containing compound used in the purification method of the present embodiment may be alone, or may be a mixture of two or more kinds. Also, the tellurium-containing compound may be applied to the production method of the present embodiment along with a variety of surfactants, a variety of crosslinking agents, a variety of acid generating agents and a variety of stabilizers.

The "organic solvent that does not inadvertently mix with water" used in the purification method of the present embodiment means an organic solvent that is not uniformly mixed with water at an arbitrary ratio. Although such an organic solvent is not particularly limited, it is preferably an organic solvent that is safely applicable to semiconductor production processes. Specifically, it is an organic solvent having a solubility in water at room temperature of less than 30%, more preferably an organic solvent having a solubility of less than 20%, and particularly preferably an organic solvent having solubility of less than 10%. It is preferable that the amount of the organic solvent to be used be 1 to 100 parts by mass based on 100 parts by mass of the tellurium-containing compound to be used.

Specific examples of the organic solvent that does not inadvertently mix with water include, but not limited to, an ether such as diethyl ether and diisopropyl ether; an ester such as ethyl acetate, n-butyl acetate and isoamyl acetate; a ketone such as methyl ethyl ketone, methyl isobutyl ketone, ethyl isobutyl ketone, cyclohexanone (CHN), cyclopentanone, 2-heptanone and 2-pentanone; a glycol ether acetate such as ethylene glycol monoethyl ether acetate, ethylene glycol monobutyl ether acetate, propylene glycol monomethyl ether acetate (PGMEA) and propylene glycol monoethyl ether acetate; an aliphatic hydrocarbon such as n-hexane and n-heptane; an aromatic hydrocarbon such as toluene and xylene; and a halogenated hydrocarbon such as methylene chloride and chloroform. Among the above, one or more organic solvents selected from the group consisting of toluene, 2-heptanone, cyclohexanone, cyclopentanone, methyl isobutyl ketone, propylene glycol monomethyl ether acetate, ethyl acetate and the like are preferable, methyl isobutyl ketone, ethyl acetate, cyclohexanone and propylene glycol monomethyl ether acetate are more preferable, and methyl isobutyl ketone and ethyl acetate are still more preferable. Methyl isobutyl ketone, ethyl acetate and the like have relatively high saturation solubility for the tellurium-containing compound and a relatively low boiling point, and it is thus possible to reduce the load in the case of industrially distilling off the solvent and in the step of removing the solvent by drying. These organic solvents can be each used alone, or can also be used as a mixture of two or more kinds.

The acidic aqueous solution used in the purification method of the present embodiment is arbitrarily selected from among aqueous solutions in which organic compounds or inorganic compounds are dissolved in water, generally known as acidic aqueous solutions. Examples of the acidic aqueous solution include, but not limited to, an aqueous mineral acid solution in which a mineral acid, such as hydrochloric acid, sulfuric acid, nitric acid and phosphoric acid, is dissolved in water; and an aqueous organic acid solution in which an organic acid, such as acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid, is dissolved in water. These acidic aqueous solutions can be each used alone, or can also be used as a combination of two or more kinds. Among these acidic aqueous solutions, aqueous solutions of one or more mineral acids selected from the group consisting of hydrochloric acid, sulfuric acid, nitric acid and phosphoric acid, or aqueous solutions of one or more organic acids selected from the group consisting of acetic acid, propionic acid, oxalic acid, malonic acid, succinic acid, fumaric acid, maleic acid, tartaric acid, citric acid, methanesulfonic acid, phenolsulfonic acid, p-toluenesulfonic acid and trifluoroacetic acid are preferable, aqueous solutions of sulfuric acid, nitric acid, and carboxylic acids such as acetic acid, oxalic acid, tartaric acid and citric acid are more preferable, aqueous solutions of sulfuric acid, oxalic acid, tartaric acid and citric acid are still more preferable, and an aqueous solution of oxalic acid is even more preferable. It is considered that polyvalent carboxylic acids such as oxalic acid, tartaric acid and citric acid coordinate with metal ions and provide a chelating effect, and thus tend to be capable of more effectively removing metals. Also, as for water used herein, it is preferable to use water, the metal content of which is small, such as ion exchanged water, according to the purpose of the purification method of the present embodiment.

The pH of the acidic aqueous solution to be used in the purification method of the present embodiment is not particularly limited, but it is preferable to regulate the acidity of the aqueous solution in consideration of an influence on the tellurium-containing compound. Normally, the pH range of the acidic aqueous solution is about 0 to 5, and is preferably 0 to 3.

The amount of the acidic aqueous solution to be used in the purification method of the present embodiment is not particularly limited, but it is preferable to regulate the amount to be used from the viewpoint of reducing the number of extraction operations for removing metals and from the viewpoint of ensuring operability in consideration of the overall amount of fluid. From the above viewpoints, the amount of the acidic aqueous solution to be used is preferably 10 to 200% by mass, and more preferably 20 to 100% by mass, based on 100% by mass of the solution (A).

In the purification method of the present embodiment, by bringing an acidic aqueous solution as described above into contact with the solution (A) containing one or more selected from the tellurium-containing compounds mentioned above and the organic solvent that does not inadvertently mix with water, metals can be extracted from the compounds in the solution (A).

When the solution (A) contains an organic solvent that inadvertently mixes with water, there is a tendency that the amount of the tellurium-containing compound to be charged can be increased, also the fluid separability is improved, and purification can be carried out at a high reaction vessel efficiency. The method for adding the organic solvent that inadvertently mixes with water is not particularly limited. For example, any of a method involving adding it to the organic solvent-containing solution in advance, a method involving adding it to water or the acidic aqueous solution in advance, and a method involving adding it after bringing the organic solvent-containing solution into contact with water or the acidic aqueous solution may be employed. Among the above, the method involving adding it to the organic solvent-containing solution in advance is preferable in terms of the workability of operations and the ease of managing the amount to be charged.

The organic solvent that inadvertently mixes with water to be used in the purification method of the present embodiment is not particularly limited, but is preferably an organic solvent that is safely applicable to semiconductor production processes. The amount of the organic solvent that inadvertently mixes with water to be used is not particularly limited as long as the solution phase and the aqueous phase separate, but is preferably 0.1 to 100 parts by mass, more preferably 0.1 to 50 parts by mass, and still more preferably 0.1 to 20 parts by mass, based on 100 parts by mass of the tellurium-containing compound.

Specific examples of the organic solvent that inadvertently mixes with water to be used in the purification method of the present embodiment include, but not limited to, an ether such as tetrahydrofuran and 1,3-dioxolane; an alcohol such as methanol, ethanol and isopropanol; a ketone such as acetone and N-methylpyrrolidone; and an aliphatic hydrocarbon such as a glycol ether such as ethylene glycol monoethyl ether, ethylene glycol monobutyl ether, propylene glycol monomethyl ether (PGME) and propylene glycol monoethyl ether. Among the above, N-methylpyrrolidone, propylene glycol monomethyl ether and the like are preferable, and N-methylpyrrolidone and propylene glycol monomethyl ether are more preferable. These solvents can be each used alone, or can also be used as a mixture of two or more kinds.

In the purification method of the present embodiment, the temperature when the solution (A) and the acidic aqueous solution are brought into contact, that is, when extraction treatment is carried out, is preferably in the range of 20 to 90°C, and more preferably 30 to 80°C. The extraction operation is not particularly limited, and is carried out by, for example, thoroughly mixing the solution (A) and the acidic aqueous solution by stirring or the like and then leaving the obtained mixed solution to stand still. Thereby, metals contained in the solution (A) containing one or more selected from the tellurium-containing compounds and the organic solvents are transferred to the aqueous phase. Also, by this operation, the acidity of the solution (A) is lowered, and the deterioration of the tellurium-containing compound can be suppressed.

By leaving the mixed solution to stand still, it is separated into an aqueous phase and a solution phase containing one or more selected from the tellurium-containing compounds and the organic solvents, and thus the solution phase containing one or more selected from the tellurium-containing compounds and the organic solvents can be recovered by decantation or the like. The time for leaving the mixed solution to stand still is not particularly limited, but it is preferable to regulate the time for leaving the mixed solution to stand still from the viewpoint of attaining better separation of the solution phase containing the organic solvents and the aqueous phase. Normally, the time for leaving the mixed solution to stand still is 1 minute or longer, preferably 10 minutes or longer, and still more preferably 30 minutes or longer. While the extraction treatment may be carried out only once, it is also effective to repeat mixing, leaving-to-stand-still, and separating operations multiple times.

It is preferable that the purification method of the present embodiment include a step of further bringing the solution phase containing the compound into contact with water after the first extraction step, thereby extracting impurities in the compound (a second extraction step). Specifically, for example, it is preferable that, after the extraction treatment is carried out using an acidic aqueous solution, the solution phase that is extracted and recovered from the aqueous solution and that contains one or more selected from the tellurium-containing compounds and the organic solvents be further subjected to extraction treatment with water. The extraction treatment with water is not particularly limited, and can be carried out by, for example, thoroughly mixing the solution phase and water by stirring or the like and then leaving the obtained mixed solution to stand still. The mixed solution after being left to stand still is separated into an aqueous phase and a solution phase containing one or more selected from the tellurium-containing compounds and the organic solvents, and thus the solution phase containing one or more selected from the tellurium-containing compounds and the organic solvents can be recovered by decantation or the like. Also, water used herein is preferably water, the metal content of which is small, such as ion exchanged water, according to the purpose of the present embodiment. While the extraction treatment may be carried out only once, it is also effective to repeat mixing, leaving-to-stand-still, and separating operations multiple times. In addition, the proportions of both used in the extraction treatment, and temperature, time and other conditions are not particularly limited, and may be the same as those of the previous contact treatment with the acidic aqueous solution.

Water that is possibly present in the thus obtained solution containing one or more selected from the tellurium-containing compounds and the organic solvents can be readily removed by performing vacuum distillation or a like operation. Also, if required, the concentration of the tellurium-containing compound can be regulated to be any concentration by adding an organic solvent to the solution.

The method for isolating the one or more selected from the tellurium-containing compounds from the obtained solution containing one or more selected from the tellurium-containing compounds and the organic solvents is not particularly limited, and publicly known methods can be carried out, such as reduced-pressure removal, separation by reprecipitation, and a combination thereof. A publicly known treatment such as concentration operation, filtration operation, centrifugation operation and drying operation can be carried out, if required.

### (Physical properties and the like of optical component forming composition)

The optical component forming composition of the present embodiment can form an amorphous film by a publicly known method such as spin coating.

### (Additional component of optical component forming composition)

The optical component forming composition of the present embodiment contains the tellurium-containing compound as a solid component. The optical component forming composition of the present embodiment may contain two or more selected from the tellurium-containing compounds.

The content of the tellurium-containing compound is preferably 0.1 to 100% by mass, more preferably 10 to 50% by mass, and still more preferably 20 to 40% by mass based on 100% by mass of the solid content of the composition for optical component formation, from the viewpoint of coatability and quality stability.

The content of the tellurium-containing compound is preferably 0.1 to 30% by mass, more preferably 0.5 to 15% by mass, and still more preferably 1.0 to 10% by mass, based on the entire mass of the composition for optical component formation, from the viewpoint of coatability and quality stability.

### <Solvent>

It is preferable that the optical component forming composition of the present embodiment further contain a solvent in addition to the tellurium-containing compound. Examples of the solvent to be used in the optical component forming composition of the present embodiment include, but not particularly limited to, an ethylene glycol monoalkyl ether acetate such as ethylene glycol monomethyl ether acetate, ethylene glycol monoethyl ether acetate, ethylene glycol mono-n-propyl ether acetate and ethylene glycol mono-n-butyl ether acetate; an ethylene glycol monoalkyl ether such as ethylene glycol monomethyl ether and ethylene glycol monoethyl ether; a propylene glycol monoalkyl ether acetate such as propylene glycol monomethyl ether acetate, propylene glycol monoethyl ether acetate (PGMEA), propylene glycol mono-n-propyl ether acetate and propylene glycol mono-n-butyl ether acetate; a propylene glycol monoalkyl ether such as propylene glycol monomethyl ether (PGME) and propylene glycol monoethyl ether; a lactate ester such as methyl lactate, ethyl lactate, n-propyl lactate, n-butyl lactate and n-amyl lactate; an aliphatic carboxylic acid ester such as methyl acetate, ethyl acetate, n-propyl acetate, n-butyl acetate, n-amyl acetate, n-hexyl acetate, methyl propionate and ethyl propionate; another ester such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutyl acetate, 3-methyl-3-methoxybutyl acetate, butyl 3-methoxy-3-methylpropionate, butyl 3-methoxy-3-methylbutyrate, methyl acetoacetate, methyl pyruvate and ethyl pyruvate; an aromatic hydrocarbon such as toluene and xylene; a ketone such as methyl ethyl ketone, 2-heptanone, 3-heptanone, 4-heptanone, cyclopentanone (CPN) and cyclohexanone (CHN); an amide such as N,N-dimethylformamide, N-methylacetamide, N,N-dimethylacetamide and N-methylpyrrolidone; and a lactone such as y-lactone. These solvents are used alone as one kind or in combination of two or more kinds.

The solvent to be used in the optical component forming composition of the present embodiment is preferably a safe solvent, more preferably at least one selected from PGMEA, PGME, CHN, CPN, 2-heptanone, anisole, butyl acetate, ethyl propionate and ethyl lactate, and still more preferably at least one selected from PGMEA, PGME and CHN.

In the optical component forming composition of the present embodiment, the relationship between the amount of the solid component and the amount of the solvent is not particularly limited, but preferably the solid component is 1 to 80% by mass and the solvent is 20 to 99% by mass, more preferably the solid component is 1 to 50% by mass and the solvent is 50 to 99% by mass, still more preferably the solid component is 2 to 40% by mass and the solvent is 60 to 98% by mass, and particularly preferably the solid component is 2 to 10% by mass and the solvent is 90 to 98% by mass, based on the total of the solid component and the solvent.

The optical component forming composition of the present embodiment may contain at least one selected from the group consisting of an acid generating agent (C), an acid crosslinking agent (G), an acid diffusion controlling agent (E) and an additional component (F), as other solid components.

In the optical component forming composition of the present embodiment, the content of the tellurium-containing compound is not particularly limited, but is preferably 10 to 99% by mass of the entire mass of the solid components (summation of the tellurium-containing compound, and optionally used solid components such as a resin, acid generating agent (C), acid crosslinking agent (G), acid diffusion controlling agent (E) and additional component (F), which will be mentioned later, hereinafter the same), more preferably 20 to 90% by mass, still more preferably 20 to 80% by mass, and particularly preferably 25 to 60% by mass.

Note that, when two or more tellurium-containing compounds are contained, the above content refers to the total amount of the two or more tellurium-containing compounds.

### <Acid generating agent (C)>

It is preferable that the optical component forming composition of the present embodiment contain one or more acid generating agents (C) that directly or indirectly generates an acid by heat. In this case, in the optical component forming composition of the present embodiment, the content of the acid generating agent (C) is preferably 0.001 to 49% by mass of the entire mass of the solid components, more preferably 1 to 40% by mass, still more preferably 3 to 30% by mass, and particularly preferably 10 to 25% by mass. By using the acid generating agent (C) at a content within the range described above, even higher refractive index is obtained.

Concerning the optical component forming composition of the present embodiment, the acid generation method is not particularly limited as long as an acid is generated in the system. By using excimer laser instead of ultraviolet such as g-ray and i-ray, finer processing is possible, and also by using electron beam, extreme ultraviolet, X-ray or ion beam as a high energy ray, further finer processing is possible.

The acid generating agent (C) is not particularly limited, and is preferably at least one selected from the group consisting of compounds represented by the following formulas (8-1) to (8-8). 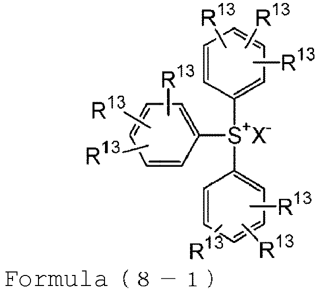 (In the formula (8-1), R¹³ may be the same as or different from each other, and are each independently a hydrogen atom, a linear, branched or cyclic alkyl group, a linear, branched or cyclic alkoxy group, a hydroxyl group or a halogen atom; and X⁻ is a sulfonic acid ion having an alkyl group, an aryl group, a halogen substituted alkyl group or a halogen substituted aryl group, or a halide ion.)

It is preferable that the compound represented by the above formula (8-1) be at least one selected from the group consisting of triphenylsulfonium trifluoromethanesulfonate, triphenylsulfonium nonafluoro-n-butanesulfonate, diphenyltolylsulfonium nonafluoro-n-butanesulfonate, triphenylsulfonium perfluoro-n-octanesulfonate, diphenyl-4-methylphenylsulfonium trifluoromethanesulfonate, di-2,4,6-trimethylphenylsulfonium trifluoromethanesulfonate, diphenyl-4-t-butoxyphenylsulfonium trifluoromethanesulfonate, diphenyl-4-t-butoxyphenylsulfonium nonafluoro-n-butanesulfonate, diphenyl-4-hydroxyphenylsulfonium trifluoromethanesulfonate, bis(4-fluorophenyl)-4-hydroxyphenylsulfonium trifluoromethanesulfonate, diphenyl-4-hydroxyphenylsulfonium nonafluoro-n-butanesulfonate, bis(4-hydroxyphenyl)-phenylsulfonium trifluoromethanesulfonate, tri(4-methoxyphenyl)sulfonium trifluoromethanesulfonate, tri(4-fluorophenyl)sulfonium trifluoromethanesulfonate, triphenylsulfonium p-toluenesulfonate, triphenylsulfonium benzenesulfonate, diphenyl-2,4,6-trimethylphenyl-p-toluenesulfonate, diphenyl-2,4,6-trimethylphenylsulfonium-2-trifluoromethylbenzenesulfonate, diphenyl-2,4,6-trimethylphenylsulfonium-4-trifluoromethylbenzenesulfonate, diphenyl-2,4,6-trimethylphenylsulfonium-2,4-difluorobenzenesulfonate, diphenyl-2,4,6-trimethylphenylsulfonium hexafluorobenzenesulfonate, diphenylnaphthylsulfonium trifluoromethanesulfonate, diphenyl-4-hydroxyphenylsulfonium-p-toluenesulfonate, triphenylsulfonium 10-camphorsulfonate, diphenyl-4-hydroxyphenylsulfonium 10-camphorsulfonate and cyclo(1,3-perfluoropropanedisulfone) imidate. 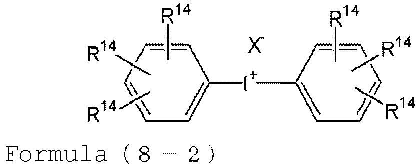 (In the formula (8-2), R¹⁴ may be the same as or different from each other, and each independently represents a hydrogen atom, a linear, branched or cyclic alkyl group, a linear, branched or cyclic alkoxy group, a hydroxyl group or a halogen atom. X⁻ is the same as above.)

It is preferable that the compound represented by the above formula (8-2) be at least one selected from the group consisting of bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium p-toluenesulfonate, bis(4-t-butylphenyl)iodonium benzenesulfonate, bis(4-t-butylphenyl)iodonium-2-trifluoromethylbenzenesulfonate, bis(4-t-butylphenyl)iodonium-4-trifluoromethylbenzenesulfonate, bis(4-t-butylphenyl)iodonium-2,4-difluorobenzenesulfonate, bis(4-t-butylphenyl)iodonium hexafluorobenzenesulfonate, bis(4-t-butylphenyl)iodonium 10-camphorsulfonate, diphenyliodonium trifluoromethanesulfonate, diphenyliodonium nonafluoro-n-butanesulfonate, diphenyliodonium perfluoro-n-octanesulfonate, diphenyliodonium p-toluenesulfonate, diphenyliodonium benzenesulfonate, diphenyliodonium 10-camphorsulfonate, diphenyliodonium-2-trifluoromethylbenzenesulfonate, diphenyliodonium-4-trifluoromethylbenzenesulfonate, diphenyliodonium-2,4-difluorobenzenesulfonate, diphenyliodonium hexafluorobenzenesulfonate, di(4-trifluoromethylphenyl)iodonium trifluoromethanesulfonate, di(4-trifluoromethylphenyl)iodonium nonafluoro-n-butanesulfonate, di(4-trifluoromethylphenyl)iodonium perfluoro-n-octanesulfonate, di(4-trifluoromethylphenyl)iodonium p-toluenesulfonate, di(4-trifluoromethylphenyl)iodonium benzenesulfonate and di(4-trifluoromethylphenyl)iodonium 10-camphorsulfonate. 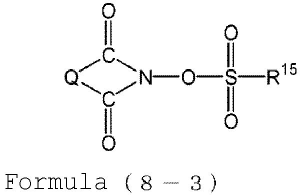 (In the formula (8-3), Q is an alkylene group, an arylene group or an alkoxylene group; and R¹⁵ is an alkyl group, an aryl group, a halogen substituted alkyl group or a halogen substituted aryl group.)

It is preferable that the compound represented by the above formula (8-3) be at least one selected from the group consisting of N-(trifluoromethylsulfonyloxy)succinimide, N-(trifluoromethylsulfonyloxy)phthalimide, N-(trifluoromethylsulfonyloxy)diphenylmaleimide, N-(trifluoromethylsulfonyloxy)bicyclo[2.2.1]hept-5-ene-2, 3-dicarboximide, N-(trifluoromethylsulfonyloxy)naphthylimide, N-(10-camphorsulfonyloxy)succinimide, N-(10-camphorsulfonyloxy)phthalimide, N-(10-camphorsulfonyloxy)diphenylmaleimide, N-(10-camphorsulfonyloxy)bicyclo[2.2.1]hept-5-ene-2,3-dicarboximide, N-(10-camphorsulfonyloxy)naphthylimide, N-(n-octanesulfonyloxy)bicyclo[2.2.1]hept-5-ene-2,3-dicarboximide, N-(n-octanesulfonyloxy)naphthylimide, N-(p-toluenesulfonyloxy)bicyclo[2.2.1]hept-5-ene-2,3-dicarboximide, N-(p-toluenesulfonyloxy)naphthylimide, N-(2-trifluoromethylbenzenesulfonyloxy)bicyclo[2.2.1]hept-5-ene-2,3-dicarboximide, N-(2-trifluoromethylbenzenesulfonyloxy)naphthylimide, N-(4-trifluoromethylbenzenesulfonyloxy)bicyclo[2.2.1]hept-5-ene-2,3-dicarboximide, N-(4-trifluoromethylbenzenesulfonyloxy)naphthylimide, N-(perfluorobenzenesulfonyloxy)bicyclo[2.2.1]hept-5-ene-2,3-dicarboximide, N-(perfluorobenzenesulfonyloxy)naphthylimide, N-(1-naphthalenesulfonyloxy)bicyclo[2.2.1]hept-5-ene-2,3-dicarboximide, N-(1-naphthalenesulfonyloxy)naphthylimide, N-(nonafluoro-n-butanesulfonyloxy)bicyclo[2.2.1]hept-5-ene-2,3-dicarboximide, N-(nonafluoro-n-butanesulfonyloxy)naphthylimide, N-(perfluoro-n-octanesulfonyloxy)bicyclo[2.2.1]hept-5-ene-2,3-dicarboximide and N-(perfluoro-n-octanesulfonyloxy)naphthylimide. 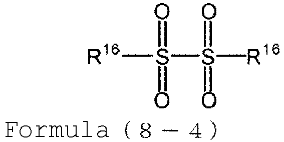 (In the formula (8-4), R¹⁶ may be the same as or different from each other, and are each independently an optionally substituted linear, branched or cyclic alkyl group, an optionally substituted aryl group, an optionally substituted heteroaryl group or an optionally substituted aralkyl group.)

It is preferable that the compound represented by the above formula (8-4) be at least one selected from the group consisting of diphenyl disulfone, di(4-methylphenyl) disulfone, dinaphthyl disulfone, di(4-tert-butylphenyl) disulfone, di(4-hydroxyphenyl) disulfone, di(3-hydroxynaphthyl) disulfone, di(4-fluorophenyl) disulfone, di(2-fluorophenyl) disulfone and di(4-trifluoromethylphenyl) disulfone. 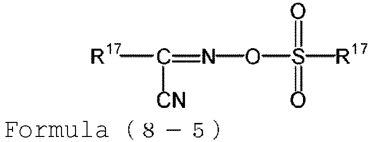 (In the formula (8-5), R¹⁷ may be the same or different, and are each independently an optionally substituted linear, branched or cyclic alkyl group, an optionally substituted aryl group, an optionally substituted heteroaryl group or an optionally substituted aralkyl group.)

It is preferable that the compound represented by the above formula (8-5) be at least one selected from the group consisting of α-(methylsulfonyloxyimino)-phenylacetonitrile, α-(methylsulfonyloxyimino)-4-methoxyphenylacetonitrile, α-(trifluoromethylsulfonyloxyimino)-phenylacetonitrile, α-(trifluoromethylsulfonyloxyimino)-4-methoxyphenylacetonitrile, α-(ethylsulfonyloxyimino)-4-methoxyphenylacetonitrile, α-(propylsulfonyloxyimino)-4-methylphenylacetonitrile and α-(methylsulfonyloxyimino)-4-bromophenylacetonitrile.

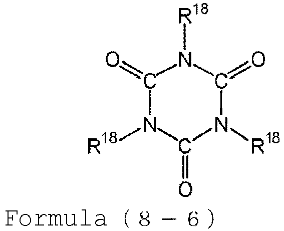

In the formula (8-6), R¹⁸ may be the same as or different from each other, and are each independently a halogenated alkyl group having one or more chlorine atoms and one or more bromine atoms. It is preferable that the halogenated alkyl group have 1 to 5 carbon atoms.

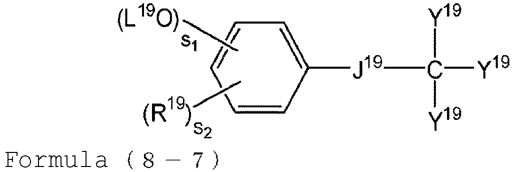

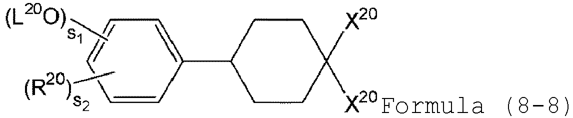

In the formulas (8-7) and (8-8), R¹⁹ and R²⁰ are each independently an alkyl group having 1 to 3 carbon atoms such as a methyl group, an ethyl group, a n-propyl group and an isopropyl group; a cycloalkyl group such as a cyclopentyl group and a cyclohexyl group; an alkoxyl group having 1 to 3 carbon atoms such as a methoxy group, an ethoxy group and a propoxy group; or an aryl group such as a phenyl group, a toluyl group and a naphthyl group, and preferably an aryl group having 6 to 10 carbon atoms. L¹⁹ and L²⁰ are each independently an organic group having a 1,2-naphthoquinonediazide group. As the organic group having a 1,2-naphthoquinonediazide group, specifically, preferable examples thereof can include a 1,2-quinonediazidesulfonyl group such as a 1,2-naphthoquinonediazide-4-sulfonyl group, a 1,2-naphthoquinonediazide-5-sulfonyl group and a 1,2-naphthoquinonediazide-6-sulfonyl group. In particular, a 1,2-naphthoquinonediazide-4-sulfonyl group and a 1,2-naphthoquinonediazide-5-sulfonyl group are preferable. s₁ is each independently an integer of 1 to 3, s₂ is each independently an integer of 0 to 4, and 1 ≤ s₁ + s₂ ≤ 5. J¹⁹ is a single bond, a polymethylene group having 1 to 4 carbon atoms, a cycloalkylene group, a phenylene group, a group represented by the following formula (8-7-1), a carbonyl group, an ester group, an amide group or an ether group, Y¹⁹ is a hydrogen atom, an alkyl group or an aryl group, and X²⁰ is each independently a group represented by the following formula (8-8-1). 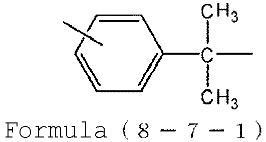 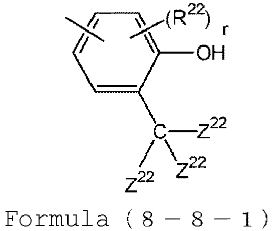 (In the formula (8-8-1), Z²² is each independently an alkyl group, a cycloalkyl group or an aryl group, R²² is an alkyl group, a cycloalkyl group or an alkoxyl group, and r is an integer of 0 to 3.)

Other examples of the acid generating agent include a bissulfonyldiazomethane such as bis(p-toluenesulfonyl)diazomethane, bis(2,4-dimethylphenylsulfonyl)diazomethane, bis(tert-butylsulfonyl)diazomethane, bis(n-butylsulfonyl)diazomethane, bis(isobutylsulfonyl)diazomethane, bis(isopropylsulfonyl)diazomethane, bis(n-propylsulfonyl)diazomethane, bis(cyclohexylsulfonyl)diazomethane, bis(isopropylsulfonyl)diazomethane, 1,3-bis(cyclohexylsulfonylazomethylsulfonyl)propane, 1,4-bis(phenylsulfonylazomethylsulfonyl)butane, 1,6-bis(phenylsulfonylazomethylsulfonyl)hexane and 1,10-bis(cyclohexylsulfonylazomethylsulfonyl)decane; and a halogen containing triazine derivative such as 2-(4-methoxyphenyl)-4,6-(bistrichloromethyl)-1,3,5-triazine, 2-(4-methoxynaphthyl)-4,6-(bistrichloromethyl)-1,3,5-triazine, tris(2,3-dibromopropyl)-1,3,5-triazine and tris(2,3-dibromopropyl) isocyanurate.

Among the acid generating agents described above, as the acid generating agent (C) to be used in the optical component forming composition of the present embodiment, an acid generating agent having an aromatic ring is preferable, and an acid generating agent represented by the formula (8-1) or (8-2) is more preferable. An acid generating agent of the formula (8-1) or (8-2), wherein X⁻ is a sulfonic acid ion having an aryl group or a halogen-substituted aryl group, is still more preferable, and an acid generating agent of the formula (8-1) or (8-2), wherein X⁻ is a sulfonic acid ion having an aryl group, is particularly preferable. Diphenyltrimethylphenylsulfonium p-toluenesulfonate, triphenylsulfonium p-toluenesulfonate, triphenylsulfonium trifluoromethanesulfonate and triphenylsulfonium nonafluoromethanesulfonate are particularly preferable. By using such an acid generating agent, line edge roughness can be reduced. The acid generating agent (C) described above can be used alone or in combination of two or more kinds.

### <Acid crosslinking agent (G)>

It is preferable that the optical component forming composition of the present embodiment contain one or more acid crosslinking agents (G) in the case of being used as an additive agent for increasing the strength of a structure. The acid crosslinking agent (G) is a compound that is capable of intramolecularly or intermolecularly crosslinking the compound represented by the above formula (A-1) in the presence of the acid generated from the acid generating agent (C). Examples of such an acid crosslinking agent (G) can include, but not particularly limited to, a compound having one or more groups (hereinafter, referred to as "crosslinkable groups") that are capable of crosslinking the tellurium-containing compound.

Specific examples of such a crosslinkable group can include, but not particularly limited to, (i) a hydroxyalkyl group or a group derived therefrom, such as a hydroxy (alkyl group having 1 to 6 carbon atoms), alkoxy having 1 to 6 carbon atoms (alkyl group having 1 to 6 carbon atoms) and acetoxy (alkyl group having 1 to 6 carbon atoms); (ii) a carbonyl group or a group derived therefrom, such as a formyl group and a carboxy (alkyl group having 1 to 6 carbon atoms); (iii) a nitrogenous group containing group such as a dimethylaminomethyl group, a diethylaminomethyl group, a dimethylolaminomethyl group, a diethylolaminomethyl group and a morpholinomethyl group; (iv) a glycidyl group containing group such as a glycidyl ether group, a glycidyl ester group and a glycidylamino group; (v) a group derived from an aromatic group such as an allyloxy having 1 to 6 carbon atoms (alkyl group having 1 to 6 carbon atoms) and an aralkyloxy having 1 to 6 carbon atoms (alkyl group having 1 to 6 carbon atoms) such as a benzyloxymethyl group and a benzoyloxymethyl group; and (vi) a polymerizable multiple bond containing group such as a vinyl group and an isopropenyl group. As the crosslinkable group of the acid crosslinking agent (G), a hydroxyalkyl group and an alkoxyalkyl group or the like are preferable, and an alkoxymethyl group is particularly preferable.

As the acid crosslinking agent (G) having the above crosslinkable group, those publicly known can be used, and examples thereof include, but not particularly limited to, compounds described in paragraphs 0096 to 0123 of International Publication No. WO 2013/024778. These crosslinkable group containing compounds can be used alone as one kind, or can be used in combination of two or more kinds.

As the acid crosslinking agent (G3) described above, a compound having two or more free α-hydroxyisopropyl groups is preferable, the benzene-based compound (1) having two or more α-hydroxyisopropyl groups, the diphenyl-based compound (2) having two or more α-hydroxyisopropyl groups and the naphthalene-based compound (3) having two or more α-hydroxyisopropyl groups are still more preferable, and an α-hydroxyisopropylbiphenyl having two or more α-hydroxyisopropyl groups and the naphthalene-based compound (3) having two or more α-hydroxyisopropyl groups are particularly preferable.

Normally, the acid crosslinking agent (G3) described above can be obtained by a method in which an acetyl group containing compound such as 1,3-diacetylbenzene is allowed to react with a Grignard reagent such as CH₃MgBr for methylation and is then hydrolyzed, or a method in which an isopropyl group containing compound such as 1,3-diisopropylbenzene is oxidized with oxygen or the like to produce a peroxide, which is then reduced.

In the optical component forming composition of the present embodiment, the content of the acid crosslinking agent (G) is preferably 0.5 to 49% by mass of the entire mass of the solid components, more preferably 0.5 to 40% by mass, still more preferably 1 to 30% by mass, and particularly preferably 2 to 20% by mass. It is preferable to set the content ratio of the acid crosslinking agent (G) described above to 0.5% by mass or more because the inhibiting effect of the solubility of the optical component forming composition in an organic solvent can be improved. On the other hand, it is preferable to set the content ratio of the acid crosslinking agent (G) described above to 49% by mass or less because a decrease in heat resistance as the optical component forming composition can be suppressed.

In addition, the content of at least one compound selected from the acid crosslinking agent (G1), acid crosslinking agent (G2) and acid crosslinking agent (G3) in the acid crosslinking agent (G) described above is not particularly limited, and the range thereof can be various depending on the type and the like of substrate to be used upon forming the optical component forming composition.

In the entire acid crosslinking agent components, the content of the alkoxymethylated melamine compound and/or the compounds represented by the formula (12-1) to the formula (12-3) is not particularly limited, and is preferably 50 to 99% by mass, more preferably 60 to 99% by mass, still more preferably 70 to 98% by mass, and particularly preferably 80 to 97% by mass. It is preferable to set the content of the alkoxymethylated melamine compound and/or the compounds represented by the formula (12-1) to the formula (12-3) to 50% by mass or more of the entire acid crosslinking agent components because resolution can be further improved, and it is preferable to set the content to 99% by mass or less because the shape of a structure is readily made to be good.

### <Acid diffusion controlling agent (E)>

The optical component forming composition of the present embodiment may contain an acid diffusion controlling agent (E) having a function of controlling diffusion of an acid generated from an acid generating agent in the optical component forming composition to inhibit any unpreferable chemical reaction or the like. By using such an acid diffusion controlling agent (E), the storage stability of the optical component forming composition is improved. Also, along with the further improvement of the resolution, the line width change of a structure due to variation in the post exposure delay time after heating can be inhibited, and the composition has extremely excellent process stability. Such an acid diffusion controlling agent (E) is not particularly limited, and examples thereof include a radiation degradable basic compound such as a nitrogen atom containing basic compound, a basic sulfonium compound and a basic iodonium compound. The acid diffusion controlling agent (E) can be used alone or in combination of two or more kinds.

The acid diffusion controlling agent described above is not particularly limited, and examples thereof include a nitrogen containing organic compound and a basic compound that is degraded by exposure. Examples of the nitrogen containing organic compound include, but not particularly limited to, a compound represented by the following formula (14).

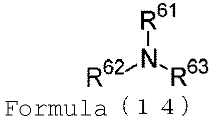

Examples of the nitrogen containing organic compound can include a compound represented by the above formula (14) (hereinafter, referred to as a "nitrogen containing compound (I)"), a diamino compound having two nitrogen atoms in the same molecule (hereinafter, referred to as a "nitrogen containing compound (II)"), a polyamino compound or polymer having three or more nitrogen atoms (hereinafter, referred to as a "nitrogen containing compound (III)"), an amide group containing compound, a urea compound and a nitrogen containing heterocyclic compound. Note that these acid diffusion controlling agents (E) may be used alone as one kind or may be used in combination of two or more kinds.

In the above formula (14), R⁶¹, R⁶² and R⁶³ each independently represent a hydrogen atom, a linear, branched or cyclic alkyl group, an aryl group or an aralkyl group. In addition, the alkyl group, the aryl group or the aralkyl group described above may be unsubstituted, or may be substituted with a hydroxyl group or the like. Here, examples of the linear, branched or cyclic alkyl group described above include, but not particularly limited to, those having 1 to 15, preferably 1 to 10 carbon atoms, and specific examples thereof include a methyl group, an ethyl group, a n-propyl group, an isopropyl group, a n-butyl group, an isobutyl group, a sec-butyl group, a t-butyl group, a n-pentyl group, a neopentyl group, a n-hexyl group, a thexyl group, a n-heptyl group, a n-octyl group, a n-ethylhexyl group, a n-nonyl group and a n-decyl group. In addition, examples of the aryl group described above include those having 6 to 12 carbon atoms, and specific examples thereof include a phenyl group, a tolyl group, a xylyl group, a cumenyl group and a 1-naphthyl group. Furthermore, examples of the aralkyl group described above include, but not particularly limited to, those having 7 to 19, preferably 7 to 13 carbon atoms, and specific examples thereof include a benzyl group, an α-methylbenzyl group, a phenethyl group and a naphthylmethyl group.

The nitrogen containing compound (I) described above is not particularly limited, and specific examples thereof can include those described in, for example, International Publication No. WO 2017/188452.

The nitrogen containing compound (II) described above is not particularly limited, and specific examples thereof can include those described in, for example, International Publication No. WO 2017/188452.

The nitrogen containing compound (III) described above is not particularly limited, and specific examples thereof can include those described in, for example, International Publication No. WO 2017/188452.

The amide group containing compound described above is not particularly limited, and specific examples thereof can include those described in, for example, International Publication No. WO 2017/188452.

The urea compound described above is not particularly limited, and specific examples thereof can include those described in, for example, International Publication No. WO 2017/188452.

The nitrogen containing heterocyclic compound described above is not particularly limited, and specific examples thereof can include those described in, for example, International Publication No. WO 2017/188452.

In addition, the radiation degradable basic compound described above is not particularly limited, and examples thereof include a sulfonium compound represented by the following formula (15-1) and an iodonium compound represented by the following formula (15-2).

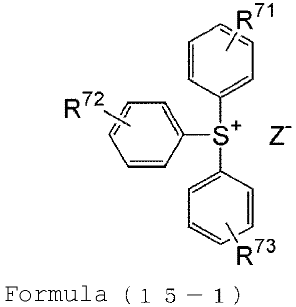

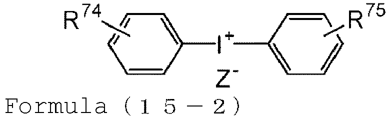

In the above formulas (15-1) and (15-2), R⁷¹, R⁷², R⁷³, R⁷⁴ and R⁷⁵ each independently represent a hydrogen atom, an alkyl group having 1 to 6 carbon atoms, an alkoxyl group having 1 to 6 carbon atoms, a hydroxyl group or a halogen atom. Z⁻ represents HO⁻, R-COO⁻, wherein R represents an alkyl group having 1 to 6 carbon atoms, an aryl group having 6 to 11 carbon atoms or an alkaryl group having 7 to 12 carbon atoms, or an anion represented by the following formula (15-3).

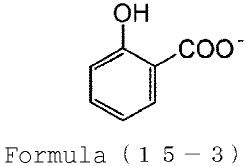

The radiation degradable basic compound described above is not particularly limited, and specific examples thereof include those described in, for example, International Publication No. WO 2017/188452.

The content of the acid diffusion controlling agent (E) is preferably 0.001 to 49% by mass of the entire mass of the solid components, more preferably 0.01 to 10% by mass, still more preferably 0.01 to 5% by mass, and particularly preferably 0.01 to 3% by mass. When the content of the acid diffusion controlling agent (E) is within the above range, a decrease in resolution, and deterioration of the optical component shape and the dimensional accuracy or the like can be further inhibited. In addition, when the content of the acid diffusion controlling agent (E) is 10% by mass or less, a decrease in sensitivity, curability and the like can be prevented. Moreover, by using such an acid diffusion controlling agent, the storage stability of the optical component forming composition is improved and the resolution, optical component shape and dimensional accuracy are also improved, thereby making the optical component forming composition extremely excellent in process stability.

### <Polymerization initiator (I)>

It is preferable that the optical component forming composition of the present embodiment contain a polymerization initiator (I) from the viewpoint of improving the curability.

A polymerization initiator that can be contained in the optical component forming composition of the present embodiment is not limited as long as it initiates, by exposure, the polymerization reaction of the tellurium-containing compound described above and one or more components selected from resins, which will be mentioned later, and a publicly known polymerization initiator can be contained. Examples of the polymerization initiator can include, but not limited to, a photoradical polymerization initiator, a photocationic polymerization initiator and a photoanionic polymerization initiator, and from the viewpoint of reactivity, a photoradical polymerization initiator is preferable.

Examples of the photoradical polymerization initiator can include, but not limited to, an alkylphenone-based photoradical polymerization initiator, an acylphosphine oxide-based photoradical polymerization initiator and an oxyphenylacetic acid ester-based photoradical polymerization initiator. From the viewpoint of reactivity, an alkylphenone-based photoradical polymerization initiator is preferable, and from the viewpoint of easy availability, 1-hydroxycyclohexyl phenyl ketone (trade name: IRGACURE 184 manufactured by BASF SE), 2,2-dimethoxy-2-phenylacetophenone (trade name: IRGACURE 651 manufactured by BASF SE) and 2-hydroxy-2-methyl-1-phenylpropanone (trade name: IRGACURE 1173 manufactured by BASF SE) are preferable.

In the composition of the present embodiment, the content of the polymerization initiator is preferably 0.1 to 20 parts by mass, more preferably 0.3 to 20 parts by mass, and still more preferably 1 to 10 parts by mass based on 100 parts by mass of the entire mass of the tellurium-containing compound and the resin.

### <Additional optional component (F)>

To the optical component forming composition of the present embodiment, within the range of not inhibiting the purpose of the present embodiment, if required, as an additional optional component (F), one kind or two kinds or more of various additive agents, such as a dissolution promoting agent, a dissolution controlling agent, a sensitizing agent, a surfactant and an organic carboxylic acid or an oxo acid of phosphorus or derivative thereof, can be added.

### (Dissolution promoting agent)

The low molecular weight dissolution promoting agent is a component having a function of, when the solubility of the tellurium-containing compound in a developing solution is too low, increasing the solubility of the compound to moderately increase the dissolution rate of the compound upon developing. The low molecular weight dissolution promoting agent can be used to the extent that the effects of the present invention is not impaired. Examples of the dissolution promoting agent described above can include a low molecular weight phenolic compound, such as a bisphenol and tris(hydroxyphenyl)methane. These dissolution promoting agents can be used alone, or can be used as a mixture of two or more kinds. The content of the dissolution promoting agent, which is arbitrarily adjusted depending on the type of the tellurium-containing compound to be used, is preferably 0 to 49% by mass of the entire mass of the solid components, more preferably 0 to 5% by mass, still more preferably 0 to 1% by mass, and particularly preferably 0% by mass.

### (Dissolution controlling agent)

The dissolution controlling agent is a component having a function of, when the solubility of the tellurium-containing compound in a developing solution is too high, controlling the solubility of the compound to moderately decrease the dissolution rate upon developing. As such a dissolution controlling agent, the one which does not chemically change in steps such as calcination of optical component, heating and development is preferable.

The dissolution controlling agent is not particularly limited, and examples thereof can include an aromatic hydrocarbon such as phenanthrene, anthracene and acenaphthene; a ketone such as acetophenone, benzophenone and phenyl naphthyl ketone; and a sulfone such as methyl phenyl sulfone, diphenyl sulfone and dinaphthyl sulfone. These dissolution controlling agents can be used alone, or can be used in combination of two or more kinds.

The content of the dissolution controlling agent is not particularly limited, and is arbitrarily adjusted depending on the type of the tellurium-containing compound to be used. However, it is preferably 0 to 49% by mass of the entire mass of the solid components, more preferably 0 to 5% by mass, still more preferably 0 to 1% by mass, and particularly preferably 0% by mass.

### (Sensitizing agent)

The sensitizing agent is a component having a function of absorbing irradiated radiation energy, transmitting the energy to the acid generating agent (C), and thereby increasing the acid production amount, and improving the apparent curability of the optical component forming composition. Such a sensitizing agent is not particularly limited, and examples thereof can include a benzophenone, a biacetyl, a pyrene, a phenothiazine and a fluorene. These sensitizing agents can be used alone, or can be used in combination of two or more kinds. The content of the sensitizing agent, which is arbitrarily adjusted depending on the type of the tellurium-containing compound to be used, is preferably 0 to 49% by mass of the entire mass of the solid components, more preferably 0 to 5% by mass, still more preferably 0 to 1% by mass, and particularly preferably 0% by mass.

### (Surfactant)

The surfactant is a component having a function of improving coatability and striation of the optical component forming composition of the present embodiment, and the like. Such a surfactant is not particularly limited, and may be any of an anionic surfactant, a cationic surfactant, a nonionic surfactant and an amphoteric surfactant. A preferable surfactant is a nonionic surfactant. The nonionic surfactant has a good affinity with a solvent to be used in production of the optical component forming composition, and is more effective. Examples of the nonionic surfactant include, but not particularly limited to, a polyoxyethylene higher alkyl ether, a polyoxyethylene higher alkyl phenyl ether and a higher fatty acid diester of polyethylene glycol. Examples of commercially available products include, hereinafter by trade name, EFTOP (manufactured by Jemco Inc.), MEGAFAC (manufactured by DIC Corporation), Fluorad (manufactured by Sumitomo 3M Limited), AsahiGuard, Surflon (hereinbefore, manufactured by Asahi Glass Co., Ltd.), Pepole (manufactured by Toho Chemical Industry Co., Ltd.), KP (manufactured by Shin-Etsu Chemical Co., Ltd.), and Polyflow (manufactured by Kyoeisha Chemical Co., Ltd.). The content of the surfactant is not particularly limited, and is arbitrarily adjusted depending on the type of the tellurium-containing compound to be used. However, it is preferably 0 to 49% by mass of the entire mass of the solid components, more preferably 0 to 5% by mass, still more preferably 0 to 1% by mass, and particularly preferably 0% by mass.

### (Organic carboxylic acid or oxo acid of phosphorus or derivative thereof)

For the purpose of prevention of curability deterioration or improvement of a structure and post exposure delay stability or the like, and furthermore, as an optional component, the optical component forming composition of the present embodiment may contain an organic carboxylic acid or an oxo acid of phosphorus or derivative thereof. Note that these components can be used in combination with the acid diffusion controlling agent, or may be used alone. The organic carboxylic acid is not particularly limited, and, for example, is suitably malonic acid, citric acid, malic acid, succinic acid, benzoic acid, salicylic acid, or the like. Examples of the oxo acid of phosphorus or derivative thereof include phosphoric acid or derivative thereof such as ester including phosphoric acid, di-n-butyl phosphate and diphenyl phosphate; phosphonic acid or derivative thereof such as ester including phosphonic acid, dimethyl phosphonate, di-n-butyl phosphonate, phenylphosphonic acid, diphenyl phosphonate and dibenzyl phosphonate; and phosphinic acid and derivative thereof such as ester including phosphinic acid and phenylphosphinic acid. Among the above, phosphonic acid is particularly preferable.

The organic carboxylic acid or the oxo acid of phosphorus or derivative thereof can be used alone, or can be used in combination of two or more kinds. The content of the organic carboxylic acid or the oxo acid of phosphorus or derivative thereof, which is arbitrarily adjusted depending on the type of the tellurium-containing compound to be used, is preferably 0 to 49% by mass of the entire mass of the solid components, more preferably 0 to 5% by mass, still more preferably 0 to 1% by mass, and particularly preferably 0% by mass.

### (Additional additive agent)

Furthermore, the optical component forming composition of the present embodiment can contain one kind or two kinds or more of additive agents other than the dissolution controlling agent, sensitizing agent and surfactant described above, within the range of not inhibiting the purpose of the present invention, if required. Examples of such an additive agent include, but not particularly limited to, a dye, a pigment and an adhesion aid. For example, when the optical component forming composition contains a dye or a pigment, a latent image of the exposed portion is visualized and influence of halation upon exposure can be alleviated, which is thus preferable. Also, when the optical component forming composition contains an adhesion aid, adhesiveness to a substrate can be improved, which is thus preferable. Furthermore, the additional additive agent is not particularly limited, and examples thereof can include a halation preventing agent, a storage stabilizing agent, a defoaming agent and a shape improving agent. Specific examples thereof can include 4-hydroxy-4'-methylchalkone.

The total content of the optional component (F) is preferably 0 to 49% by mass of the entire mass of the solid components, more preferably 0 to 5% by mass, still more preferably 0 to 1% by mass, and particularly preferably 0% by mass.

In the optical component forming composition of the present embodiment, the contents of the tellurium-containing compound, a resin, which will be mentioned later, the acid crosslinking agent (G), the acid generating agent (C), the acid diffusion controlling agent (E), the polymerization initiator (I) and the optional component (F) is preferably 10 to 99/0.1 to 50/0.1 to 50/0.01 to 5/0 to 5/0 to 20, more preferably 20 to 90/1 to 50/1 to 50/0.1 to 5/0 to 5/0 to 10, still more preferably 20 to 80/5 to 40/5 to 40/0.5 to 4/0 to 4/0 to 5, and particularly preferably 20 to 60/10 to 30/10 to 30/1 to 3/0 to 3/0 to 3, in % by mass, based on the solid content.

The content ratio of each component is selected from each range so that the summation thereof is 100% by mass. When the content ratio is as described above, performance such as sensitivity, resolution and developability becomes further excellent.

The method for preparing the optical component forming composition of the present embodiment is not particularly limited, and examples thereof include a method involving dissolving each component in a solvent upon use into a uniform solution, and then if required, filtering the solution through a filter or the like with a pore diameter of about 0.2 µm, for example.

### <Resin>

The optical component forming composition of the present embodiment may contain, in addition to the tellurium-containing compound described above, a resin to be used as an optical component forming material such as a material for lithography (in particular, a resist material). The "resin" as used herein refers to a film forming component excluding the tellurium-containing compound, a solvent, which will be mentioned later, the acid generating agent, the acid crosslinking agent, the acid diffusion controlling agent, the polymerization initiator and the additional component, and follows a concept of also encompassing low molecular weight compounds.

The resin is not particularly limited, and examples thereof include a naphthol resin, a modified resin obtained by modifying a xylene formaldehyde resin with a phenol (for example, phenol, naphthol and the like), a modified resin obtained by modifying a naphthalene formaldehyde resin with a phenol (for example, phenol, naphthol and the like), a dicyclopentadiene resin, a novolac resin, a polyvinylphenol, a polyacrylic acid, a polyvinyl alcohol, a styrene-maleic anhydride resin, and a polymer containing acrylic acid, vinyl alcohol or vinylphenol as a monomeric unit, or a derivative thereof. These resins can be used alone as one kind, or can be used in combination of two or more kinds. Among the above, from the viewpoint of achieving the action effects of the present invention more effectively and reliably, the resin is preferably at least one selected from the group consisting of a naphthol resin, a modified resin obtained by modifying a xylene formaldehyde resin with naphthol and a modified resin obtained by modifying a naphthalene formaldehyde resin with phenol, and is more preferably a modified resin obtained by modifying a naphthalene formaldehyde resin with phenol.

The number average molecular weight (Mn) of the resin is preferably 300 to 5,000, preferably 300 to 3,000, and still more preferably 500 to 2,000.

The weight average molecular weight (Mw) of the resin is preferably 500 to 20,000, more preferably 800 to 10,000, and still more preferably 1,000 to 8,000.

The dispersity (Mw/Mn) of the resin is preferably 1.0 to 5.0, more preferably 1.2 to 4.0, and still more preferably 1.5 to 3.0.

The number average molecular weight (Mn), weight average molecular weight (Mw) and dispersity (Mw/Mn) mentioned above can be determined in terms of polystyrene by gel permeation chromatography (GPC) analysis. More specifically, measurement methods for the above are according to the methods described in Examples.

The content of the resin is not particularly limited, and is preferably 1000 parts by mass or less, more preferably 500 parts by mass or less, still more preferably 200 parts by mass or less, and particularly preferably 100 parts by mass, based on 100 parts by mass of the total amount of the tellurium-containing compound of the present embodiment. In addition, when the resin is contained, the content of the resin is not particularly limited, and is preferably 10 parts by mass or more, more preferably 30 parts by mass or more, still more preferably 50 parts by mass or more, and particularly preferably 80 parts by mass or more, based on 100 parts by mass of the total amount of the tellurium-containing compound of the present embodiment.

In addition, cured products of the present embodiment can be obtained by curing the optical component forming composition and can be used as a variety of resins. These cured products can be used for various applications as a highly versatile material imparting various characteristics such as high melting point, high refractive index and high transparency. Note that such cured products can be obtained by using subjecting the composition described above to a publicly known method corresponding to each composition, such as photoirradiation and heating.

These cured products can be used as a variety of synthetic resins such as an epoxy resin, a polycarbonate resin and an acrylic resin. Furthermore, they can be used as optical components such as lenses and optical sheets by taking advantage of their functionality.

### Examples

Hereinafter, the present embodiment will be more specifically described with reference to Examples. However, the present invention is not limited to these Examples. Below, methods for measuring compounds and methods for evaluating optical component performance and the like in Examples are presented.

### [Measurement method]

### (1) Structure of compound

The structure of a compound was confirmed by ¹H-NMR measurement using "Advance 600II spectrometer" manufactured by Bruker Inc. under the following conditions.
Frequency: 400 MHz
Solvent: d6-DMSO (except Production Example 4, which will be mentioned later)
Internal standard: tetramethylsilane (TMS)
Measurement temperature: 23°C

### (2) Mn, Mw and Mw/Mn

The Mn, Mw and Mw/Mn were determined in terms of polystyrene by gel permeation chromatography (GPC) analysis under the following measurement conditions.
Apparatus: "Shodex GPC-101 model" manufactured by Showa Denko K.K.
Column: "KF-80M" x 3 manufactured by Showa Denko K.K.
Eluent: tetrahydrofuran (hereinafter, also referred to as "THF")
Flow rate: 1 mL/min
Temperature: 40°C

### [Evaluation method]

### (1) Solubility of compound in organic solvent

With respect to the solubility of a compound in an organic solvent, the solubility of the compound in propylene glycol monomethyl ether acetate was measured. The solubility was evaluated according to the following criteria, using the amount of dissolution in propylene glycol monomethyl ether acetate. Note that, for the measurement of the amount of dissolution, the evaluation was carried out by precisely weighing the compound in a test tube at 23°C, adding propylene glycol monomethyl ether acetate to a predetermined concentration, applying ultrasonic waves for 30 minutes with an ultrasonic cleaning machine, visually observing the subsequent state of the liquid, and determining the concentration of the completely dissolved amount as the basis.
A: 5.0% by mass ≤ amount of dissolution
B: 3.0% by mass ≤ amount of dissolution < 5.0% by mass
C: amount of dissolution < 3.0% by mass

### (2) Storage stability and thin film formation of optical component forming composition

The storage stability of an optical component forming composition containing a compound was evaluated by leaving the optical component forming composition to stand still for three days at 23°C after preparation and then visually observing the optical component forming composition for the presence and absence of precipitates. The optical component forming composition after being left to stand still for three days was evaluated as "A" when it was a uniform solution without precipitates, and evaluated as "C" when precipitates were confirmed. In addition, a clean silicon wafer was spin coated with the optical component forming composition in a uniform state, and then prebaked (PB) in an oven of 110°C to form an optical component forming film with a thickness of 1 µm. The prepared optical component forming composition was evaluated as "A" when it formed a good film, and evaluated as "C" when the formed film had defects.

### (3) Refractive index and transparency

A clean silicon wafer was spin coated with the uniform optical component forming composition, and then prebaked in an oven of 110°C to form a film with a thickness of 1 µm. With respect to that film, the refractive index (λ = 589.3 nm) at 25°C was measured using a variable angle spectroscopic ellipsometer "M-2000DI-YK" manufactured by J. A. Woollam Co., Inc. The prepared film was evaluated as "A" when the refractive index was 1.8 or more, evaluated as "B" when the refractive index was 1.6 or more and less than 1.8, and evaluated as "C" when the refractive index was less than 1.6. Also, the film was evaluated as "A" when the transparency (λ = 632.8 nm) was 90% or more, and evaluated as "C" when the transparency was less than 90%.

### [Production Example 1] Synthesis of CR-1

A four necked flask (internal capacity: 10 L) equipped with a Dimroth condenser tube, a thermometer and a stirring blade, and having a detachable bottom was prepared. To this four necked flask, 1.09 kg (7 mol) of 1,5-dimethylnaphthalene (manufactured by Mitsubishi Gas Chemical Company, Inc.), 2.1 kg (28 mol as formaldehyde) of a 40 mass% aqueous formalin solution (manufactured by Mitsubishi Gas Chemical Company, Inc.), and 0.97 mL of a 98 mass% sulfuric acid (manufactured by Kanto Chemical Co., Inc.) were added in a nitrogen stream, and the mixture was allowed to react for 7 hours while being refluxed at 100°C at normal pressure. Subsequently, 1.8 kg of ethylbenzene (manufactured by Wako Pure Chemical Industries, Ltd., a special grade reagent) was added as a diluting solvent to the reaction solution, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a dimethylnaphthalene formaldehyde resin as a light brown solid. The molecular weight of the obtained dimethylnaphthalene formaldehyde resin was as follows: Mn: 562, Mw: 1168, and Mw/Mn: 2.08.

Subsequently, a four necked flask (internal capacity: 0.5 L) equipped with a Dimroth condenser tube, a thermometer and a stirring blade was prepared. To this four necked flask, 100 g (0.51 mol) of the dimethylnaphthalene formaldehyde resin obtained as mentioned above, and 0.05 g of p-toluenesulfonic acid were added in a nitrogen stream, and the temperature was raised to 190°C at which the mixture was then heated for 2 hours, followed by stirring. Subsequently, 52.0 g (0.36 mol) of 1-naphthol was further added thereto, and the temperature was further raised to 220°C at which the mixture was allowed to react for 2 hours. After dilution with a solvent, neutralization and washing with water were performed, and the solvent was distilled off under reduced pressure to obtain 126.1 g of a modified resin (CR-1) as a black brown solid. The obtained resin (CR-1) had Mn: 885, Mw: 2220, and Mw/Mn: 2.51. In addition, the solubility of the obtained resin (CR-1) in PGMEA was evaluated according to the measurement method mentioned above, and as a result, it was evaluated to be 5% by mass or more (evaluation A).

### [Production Example 2] Synthesis of TOX-2

In a container (internal capacity: 100 mL) equipped with a stirrer, a condenser tube and a burette, 1.0 g (2.8 mmol) of tetraethoxytellurium(IV) (product from Alfa Aesar, purity 85%) dissolved in 20 mL of tetrahydrofuran was placed, and 0.6 g (6.0 mmol) of acetylacetone dissolved in 5 mL of tetrahydrofuran was further added. After refluxing the mixture for 1 hour, the solvent was distilled off under reduced pressure to obtain 0.6 g of a compound represented by the following formula (TOX-2).

From the chemical shift of ¹H-NMR before and after the reaction, it was confirmed that the compound represented by the formula (TOX-2) was obtained.

### [Table 1]

**Table 1**

| Ligand | Proton | Chemical shift (ppm) | |
|---|---|---|---|
| | | Before reaction | After reaction |
| Acetylacetone | -CH₃ | 2.2 | 2.3 |
| | -CH₂-(keto form) | 3.6 | Not observed |
| | -CH= (enol form) | 5.5 | 5.4 |
| | -OH (enol form) | 15.8 | Not observed |

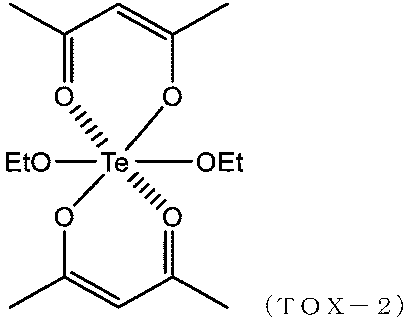

### [Production Example 3] Synthesis of TOX-3

In a container (internal capacity: 100 mL) equipped with a stirrer, a condenser tube and a burette, 1.0 g (2.8 mmol) of tetraethoxytellurium(IV) (product from Alfa Aesar, purity 85%) dissolved in 20 mL of tetrahydrofuran was placed, and 0.8 g (5.6 mmol) of 2,2-dimethyl-3,5-hexanedione dissolved in 5 mL of tetrahydrofuran was further added. After refluxing the mixture for 1 hour, the solvent was distilled off under reduced pressure to obtain 0.7 g of a compound represented by the following formula (TOX-3).

From the chemical shift of ¹H-NMR before and after the reaction, it was confirmed that the compound represented by the formula (TOX-3) was obtained.

### [Table 2]

**Table 2**

| Ligand | Proton | Chemical shift (ppm) | |
|---|---|---|---|
| | | Before reaction | After reaction |
| 2,2-Dimethyl-3,5-hexanedione | -(CH₃)₃ | 1.2 | 1.3 |
| | -CH₃ | 2.1 | 2.2 |
| | -CH₂-(keto form) | 3.7 | Not observed |
| | -CH= (enol form) | 5.7 | 5.6 |
| | -OH (enol form) | 15.8 | Not observed |

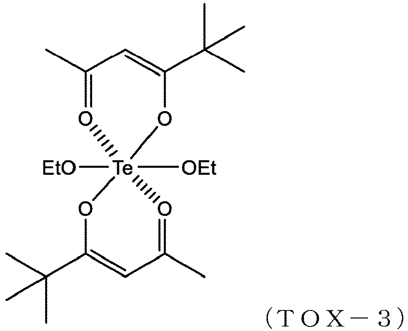

### [Production Example 4] Synthesis of TOX-4

In a container (internal capacity: 100 mL) equipped with a stirrer, a condenser tube and a burette, 1.0 g (2.8 mmol) of tetraethoxytellurium(IV) (product from Alfa Aesar, purity 85%) dissolved in 20 mL of tetrahydrofuran was placed, and 0.5 g (5.8 mmol) of methacrylic acid was further added. After refluxing the mixture for 1 hour, the solvent was distilled off under reduced pressure to obtain 0.5 g of a compound represented by the following formula (TOX-4).

From the chemical shift of ¹H-NMR before and after the reaction (solvent: deuterated chloroform), it was confirmed that the compound represented by the formula (TOX-4) was obtained.

### [Table 3]

**Table 3**

| Ligand | Proton | Chemical shift (ppm) | |
|---|---|---|---|
| | | Before reaction | After reaction |
| Methacrylic acid | -CH₃ | 2.0 | 1.9 |
| | =CH₂ ① | 5.7 | 5.6 |
| | =CH₂ ② | 6.3 | 6.2 |
| | -COOH | 12.0 | 7.9 |

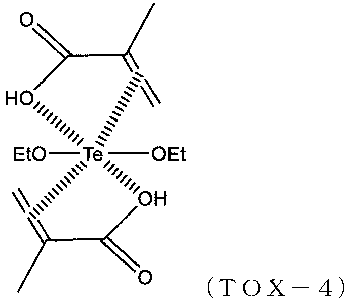

### [Examples 1 to 8 and Comparative Example 1]

### (Preparation of optical component forming composition)

Optical component forming compositions were prepared according to the recipe shown in the following Table 4 using compounds synthesized in the above Production Examples 1 to 4. Note that, for the components of the optical component forming compositions in Table 4, the following acid generating agent (C), acid crosslinking agent (G), acid diffusion controlling agent (E) and solvent (S-1) were used.

### [Acid generating agent (C)]

P-1: triphenylsulfonium trifluoromethanesulfonate (manufactured by Midori Kagaku Co., Ltd.)

### [Acid crosslinking agent (G)]

G-1: MX-270 (manufactured by Sanwa Chemical Co., Ltd.)

### [Acid diffusion controlling agent (E)]

Q-1: trioctylamine (manufactured by Tokyo Kasei Kogyo Co., Ltd.)

### [Polymerization initiator (I)]

I-1: IRGACURE 184 (manufactured by BASF SE)

### [Solvent]

S-1: propylene glycol monomethyl ether acetate (manufactured by Tokyo Kasei Kogyo Co., Ltd.)

The "storage stability" of the obtained optical component forming compositions was evaluated according to the measurement method mentioned above. In addition, the "film formation" was evaluated using the optical component forming compositions in a uniform state. The obtained results are shown in Table 4. TOX-1, which was used for Example 1 and Example 5, is shown below.

Te(OEt)₄ (TOX-1)

### [Table 4]

**Table 4**

| | Tellurium containing compound | | Composition for optical component formation | | | | | | Evaluation | | | |
|---|---|---|---|---|---|---|---|---|---|---|---|---|
| | Tellurium containing compound/mixture of tellurium-containing compound and resin | Solubility in organic solvent | Tellurium containing compound/mixture of tellurium-containing compound and resin [g] | Acid generating agent (C) P-1 [g] | Acid crosslinking agent (G) C-1 [g] | Acid diffusion controllin g agent (E) Q-1 [g] | Polymerization initiator (I) [g] | Solvent S-1 [g] | Storage stability | Thin film formation | Refractive index | Transparency |
| Example 1 | Mixture of TOX-1:CR-1 = 1:1 | A | 0.75 | 0.3 | 0.25 | 0.03 | 0 | 25 | A | A | A | A |
| Example 2 | Mixture of TOX-2:CR-1 = 1:1 | A | 0.75 | 0.3 | 0.25 | 0.03 | 0 | 25 | A | A | A | A |
| Example 3 | Mixture of TOX-3:CR-1 = 1:1 | A | 0.75 | 0.3 | 0.25 | 0.03 | 0 | 25 | A | A | A | A |
| Example 4 | Mixture of TOX-4:CR-1 = 1:1 | A | 0.75 | 0.3 | 0.25 | 0.03 | 0 | 25 | A | A | A | A |
| Example 5 | TOX-1 | A | 0.75 | 0 | 0 | 0 | 0 | 15 | A | A | A | A |
| Example 6 | TOX-2 | A | 0.75 | 0 | 0 | 0 | 0 | 15 | A | A | A | A |
| Example 7 | Mixture of TOX-3:CR-1 = 1:1 | A | 0.75 | 0.3 | 0.25 | 0.03 | 0.03 | 25 | A | A | A | A |
| Example 8 | Mixture of TOX-4:CR-1 = 1:1 | A | 0.75 | 0.3 | 0.25 | 0.03 | 0.03 | 25 | A | A | A | A |
| Comparative Example 1 | CR-1 | A | 0.75 | 0.3 | 0.25 | 0.03 | 0 | 25 | A | A | C | C |

As can be seen from Table 4, it was confirmed that the compounds used in Examples 1 to 8 have good solubility.

In addition, with respect to the storage stability evaluation, it was confirmed that the optical component forming compositions obtained in Examples 1 to 8 have no precipitation and have good storage stability (evaluation: A).

Upon evaluating the film formation according to the measurement method described above, it was found that the optical component forming compositions obtained in Examples 1 to 8 can form excellent films.

From the results described above, it was found that the tellurium-containing compound has high solubility in an organic solvent and that the optical component forming composition containing the tellurium-containing compound has good storage stability, is capable of forming a film, and can impart high refractive index and high transmittance. As long as the requirements of the present invention mentioned above are met, compounds other than the compounds described in Examples also exhibit the same effects.

### Industrial Applicability

The optical component forming composition of the present invention has a specific structure, contains a compound having high solubility in an organic solvent, has good storage stability, is capable of forming a film, and can impart a structure with a high refractive index. Accordingly, the present invention is useful in the optical component field and the like in which optical component forming compositions with high refractive index are used.

## Claims

1. An optical component forming composition comprising a compound represented by the following formula (1):
[LₓTe(OR¹)_{y}] (1)
wherein:
L is a ligand other than OR¹;
R¹ is any of: a hydrogen atom; a substituted or unsubstituted, linear alkyl group having 1 to 20 carbon atoms, or branched or cyclic alkyl group having 3 to 20 carbon atoms; a substituted or unsubstituted aryl group having 6 to 20 carbon atoms; a substituted or unsubstituted alkenyl group having 2 to 20 carbon atoms; and a substituted or unsubstituted alkynyl group having 2 to 20 carbon atoms;
x is an integer of 0 to 6;
y is an integer of 0 to 6;
a sum of x and y is 1 to 6;
when x is 2 or more, a plurality of L may be the same or different; and
when y is 2 or more, a plurality of R¹ may be the same or different.

2. The optical component forming composition according to claim 1, wherein, in the compound represented by the above formula (1), x is an integer of 1 to 6.

3. The optical component forming composition according to claim 1 or 2, wherein, in the compound represented by the above formula (1), y is an integer of 1 to 6.

4. The optical component forming composition according to any one of claims 1 to 3, wherein, in the compound represented by the above formula (1), R¹ is, a substituted or unsubstituted, linear alkyl group having 1 to 6 carbon atoms, or branched or cyclic alkyl group having 3 to 6 carbon atoms.

5. The optical component forming composition according to any one of claims 1 to 4, wherein, in the compound represented by the above formula (1), L is a bi- or higher- dentate ligand.

6. The optical component forming composition according to any one of claims 1 to 5, wherein, in the compound represented by the above formula (1), L is any of acetylacetonato, 2,2-dimethyl-3,5-hexanedione, ethylenediamine, diethylenetriamine and methacrylic acid.

7. The optical component forming composition according to any one of claims 1 to 6, further comprising a solvent.

8. The optical component forming composition according to any one of claims 1 to 7, further comprising an acid generating agent.

9. The optical component forming composition according to any one of claims 1 to 8, further comprising an acid crosslinking agent.

10. The optical component forming composition according to any one of claims 1 to 9, further comprising an acid diffusion controlling agent.

11. The optical component forming composition according to any one of claims 1 to 10, further comprising a polymerization initiator.

12. A cured product obtained by using the optical component forming composition according to any one of claims 1 to 11.
